# EUROPEAN PATENT SPECIFICATION

(11) **EP 4 345 529 B1**
(45) Date of publication and mention of the grant of the patent: **01.04.2026**
(21) Application number: 22871738.5
(22) Date of filing: 24.08.2022
(51) Int. Cl.: H01R 13/621, H01R 13/74, G02B 27/01, H04M 1/02, H01R 24/60

(54) **ELECTRONIC DEVICE ASSEMBLY**
ELEKTRONISCHE VORRICHTUNGSANORDNUNG
ENSEMBLE DISPOSITIF ÉLECTRONIQUE

(30) Priority: 23.09.2021 CN 202111115497
(43) Date of publication of application: 03.04.2024
(73) Proprietor: Qingdao Pico Technology Co., Ltd., Qingdao, Shandong 266100 (CN)
(72) Inventor: LI, Haigang, Beijing 100086 (CN)
(74) Representative: Marks & Clerk LLP
(86) International application number: PCT/CN2022/114532
(87) International publication number: WO 2023/045685

(56) References cited:
- EP-A1- 3 883 068
- CN-A- 110 190 461
- CN-A- 113 131 562
- CN-A- 113 866 981
- CN-U- 207 265 366
- CN-U- 209 417 419
- CN-U- 210 723 527
- CN-U- 212 062 827
- CN-U- 212 784 017
- TW-U- M 424 975
- US-A- 5 772 471
- US-A1- 2007 082 536
- US-A1- 2008 254 681

## Description

### FIELD

The present disclosure relates to the field of consumer electronics, and more particularly, to an electronic device assembly.

### BACKGROUND

With the development of technology, electronic devices are an indispensable part for people's daily life. In order to meet consumers' more demands, data transmission technology is more widely used in the field of electronic devices. Data transmission generally includes wired transmission and wireless transmission. The wired transmission is usually implemented through data cables.

In the related art, a majority of electronic devices are equipped with data cables. Through a connection between a data cable and a data interface provided on an electronic device, the external or internal data transmission or the charging functions can be achieved. However, in the process of data transmission or charging, the electronic device may be moved based on actual demands. When the electronic device is in a dynamic application scenario, the data cable and the electronic device, which are connected to each other merely through the data interface, are likely to disengage from one another, thereby resulting in transmission interruption and negatively affecting usage experience.
US2008/254681A1 discloses an electronic data transfer cable comprising (a) a first end; (b) a second end; (c) a plurality of data transmission wires running the length of the data transmission cable; (d) an insulating sheath disposed at one of said data transfer cable first or second ends having a first end, a second end opposite the first end and connected to either of the data transfer cable first or second ends, at least one side surface extending between said insulating sheath first and second ends, and a tab extending outwardly from the sheath side surface and defining a through-hole; (e) a connector which slidably engages the through-hole; and (f) a plug extending outwardly from the sheath first end, the plug having a plurality of data transfer pins whereat said plurality of data transmission wires terminate.
CN113131562A discloses a charging control method and apparatus for an electronic device, and an electronic device, where the electronic device includes a first external interface, the first external interface is coupled to a first data line by being coupled to a first electronic device interface on the first data line, and the first data line further includes a plurality of first external device interfaces; the method comprises the following steps: the method comprises the steps of taking a first external device interface with the largest rated voltage in a plurality of first external device interfaces as a target interface and determining whether an external device is coupled to the first external device interface; if the target interface is coupled with the external equipment, the target interface is used as a charging interface corresponding to the electronic equipment to receive electric energy; if the target interface is determined not to be coupled with the external equipment, taking a next first external equipment interface of the current target interface as the target interface according to a preset sequence, and re-determining whether the target interface is coupled with the external equipment; the preset sequence is obtained by arranging the plurality of external equipment interfaces according to the sequence of the rated voltages of the plurality of first external equipment interfaces from large to small.
US5772471A discloses a bracket adapted to be mounted to a conductive panel for mounting a shielded connector thereto, where the connector is of a design intended for mounting to a circuit board but is instead terminated to a cable. Upper and lower wall sections extend rearwardly from bracket body section each having at least one locking tab extending forwardly and inwardly almost to body section. Connector is urged forwardly against body section until locking tabs seat behind flanges of connector shield and press against shield to establish ground connections therewith.
EP3883068A1 discloses an assembly for sealing a juncture of a cable in a wall. The wall includes at least one aperture. The aperture is used for coupling a connector comprised in the cable. A cable end is provided with at least one flange. The flange surrounds at least in part the cable end. The assembly includes at least one strain relief element. The strain relief element is configured, once in a position to cooperate with the wall and the flange, to press, directly or indirectly, the flange against the wall when the connector is coupled while the strain relief element remains attached to the wall, so that the flange surrounds, directly or indirectly, the aperture and prevents, directly or indirectly, any foreign matter from passing the juncture of the cable at the aperture.

### SUMMARY

An object of the present disclosure is to provide a new technical solution to the above technical problem.

According to a first aspect of the present disclosure, an electronic device assembly is provided. The electronic device assembly includes an electronic device and a data cable. The electronic device includes a housing. The housing has a data interface. The data cable includes a cable body, a connection plug, and a fixing structure. The connection plug is disposed at one end of the cable body. The fixing structure is disposed on a side of the connection plug. When the connection plug is plugged into the data interface, the fixing structure is capable of fixing the connection plug to the housing. The fixing structure includes a fixing base disposed on the side of the connection plug, and a fastener movably disposed on the fixing base; the housing has an engagement portion; and the fastener is fixedly connected to the engagement portion. The fixing base has a first through hole and a second through hole perpendicular to each other, a direction of the first through hole being parallel to an extending direction of the cable body, a direction of the second through hole being perpendicular to the extending direction of the cable body, the fixing base being detachably sleeved on the side of the connecting plug via the first through hole, and a part of the fastener penetrating and disposed in the second through hole. The fastener includes a limiting end and a fastening end, the limiting end being located at outside of the second through hole and having a greater diameter than the second through hole, and the fastening end being configured to be fixedly connected to the engagement portion. A plug-in direction of the connection plug is perpendicular to an extension direction of the cable body.

According to embodiments of the present disclosure, by providing the fixing structure on a side of the connection plug of the data cable, the connection plug can be fixed to the housing through the fixing structure when the electronic device and the data cable are connected to each other. In this way, the firmness of connection between the electronic device and the data cable is strengthened, and the reliability of data transmission is ensured.

Other features and advantages of the present disclosure can become apparent from the following detailed description of exemplary embodiments of the present disclosure with reference to the accompanying drawings.

### BRIEF DESCRIPTION OF THE DRAWINGS

The accompanying drawings, which are incorporated in and consist a part of the specification, illustrate embodiments of the present disclosure and, together with their description, serve to explain the principles of the present disclosure.
FIG. 1 is a schematic diagram of a virtual reality (VR) device and a transmission cable in the related art.
FIG. 2 is a schematic structural diagram of an electronic device assembly according to the present disclosure.
FIG. 3 is a schematic structural diagram illustrating a connection position according to the present disclosure, where a data cable and a housing are connected to each other.
FIG. 4 is a cross-sectional view of FIG. 3.
FIG. 5 is a cross-sectional view illustrating a structure when a data cable and a housing are connected to each other according to the present disclosure.
FIG. 6 is a schematic structural diagram of a data cable according to the present disclosure.
FIG. 7 is an exploded view of FIG. 6.
FIG. 8 is a cross-sectional view of FIG. 6.
FIG. 9 is a cross-sectional view illustrating that a detachment of a fastener in FIG. 6 is limited by a limiting boss.
FIG. 10 is a schematic structural diagram of a housing with a threaded hole according to the present disclosure.
FIG. 11 is a schematic structural diagram of a housing with a metal nut according to the present disclosure.

### Description of reference numerals:

100. Electronic device; 101. Housing; 102. Data interface; 103. Threaded hole; 104. Metal nut; 200. Data cable; 201. Cable body; 202. Connection plug; 203. Fixing base; 2031. Through hole; 2032. Limiting boss; 204. Fastener; 2041. Limiting end; 2042. Fastening end.
1. Connection cable; 2. VR device; and 21. Host interface.

### DETAILED DESCRIPTION

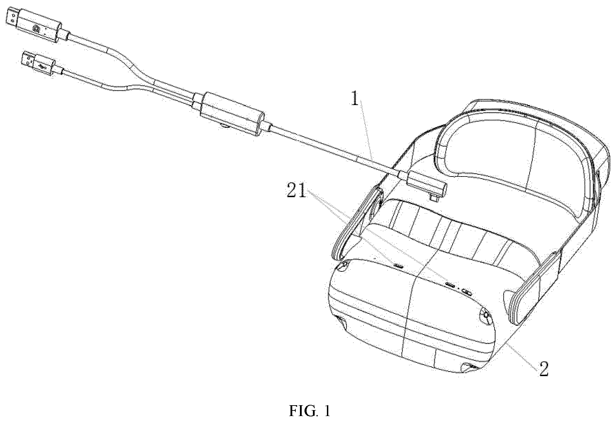

In the related art, an electronic device often requires data transmission to and from the outside. Conventional data cables connected to the electronic devices are likely to disengage, resulting in unstable connection and disconnection. For example, a virtual reality (VR) device for audio and video entertainment, games, social interaction, simulation, remote control, education, medical care, etc., generally needs to connect to another device, such as a laptop, a smart tablet and a cell phone through a data cable. As illustrated in FIG. 1, in the VR device 2, an existing connection is usually to directly plug a plug of a connection cable 1 into a host interface 21 of the VR device 2. Due to the interactive nature of the VR device 2 and mobility of use scenarios, in the use process, the connection cable 1 needs to move with the device or the user due to the user's action such as bowing head, swinging head, bending, squatting, raising hands, and turning. The functions can be only guaranteed when the connection cable 1 is firmly and stably connected to the VR device 2.

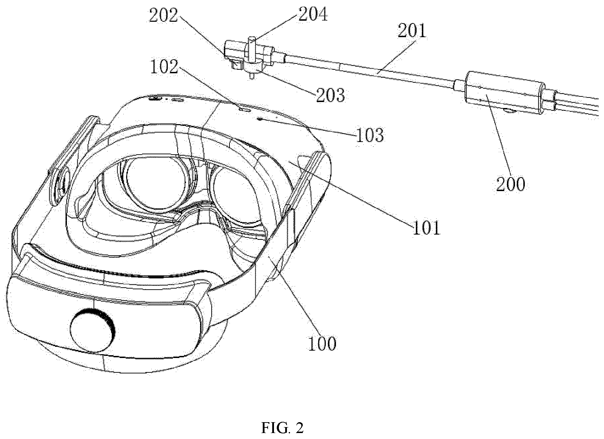

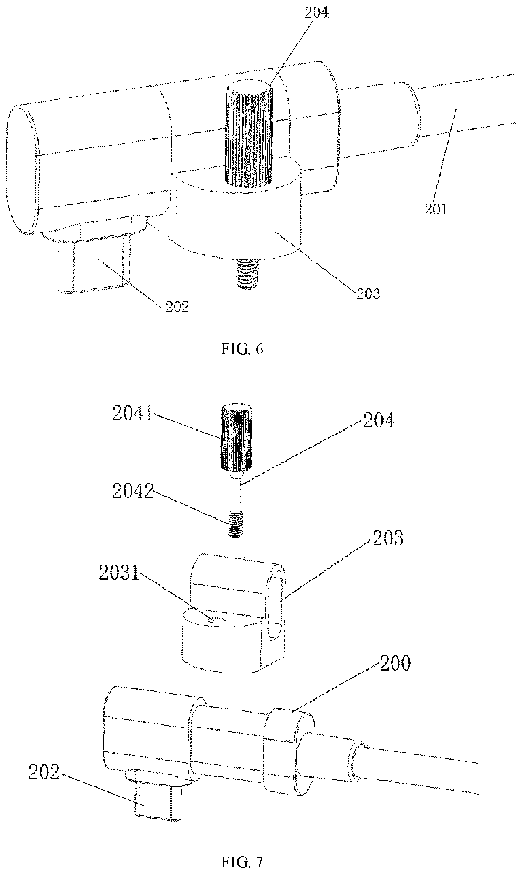

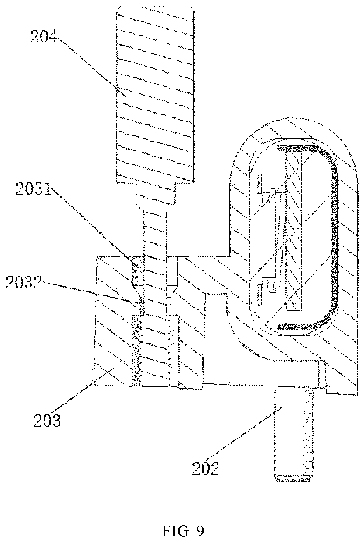

An electronic device assembly according to the present disclosure is described below with reference to FIG. 2 to FIG. 11. The electronic device assembly includes an electronic device 100 and a data cable 200. The electronic device 100 has a housing 101, and the housing 101 has a data interface 102. The data cable 200 includes a cable body 201, a connection plug 202, and a fixing structure. The connection plug 202 is disposed at one end of the cable body 201, and the fixing structure is disposed on one side of the connection plug 202. When the connection plug 202 is plugged into the data interface 102, the fixing structure can fix the connection plug 202 to the housing 101.

For example, as illustrated in FIG. 2, the electronic device 100 has the data interface 102 for an external device, and the data cable 200 may be plugged into the data interface 102 through the connection plug 202 to enable an external interaction of the electronic device 100. In this embodiment, the fixing structure is disposed on one side of the connection plug 202 of the data cable 200, and the fixing structure is configured to fix the connection plug 202 to the housing 101. In this way, the firmness of connection between the data cable 200 and the electronic device 100 can be enhanced, preventing the disengagement or disconnection of the data cable 200 from the electronic device 100 in use. The fixing structure may have various forms. In an example, the fixing structure may be a fastener for fastening the housing 101 and the connection plug 202, to strengthen the firmness of connection. In another example, the fixing structure may be a suction structure and is sucked to the housing 101, to ensure the firmness of connection between the connection plug 202 and the housing 101. The specific structure and fixing manner of the fixing structure may be selected according to actual characteristics of the electronic device 100, and they are not limited in the present disclosure.

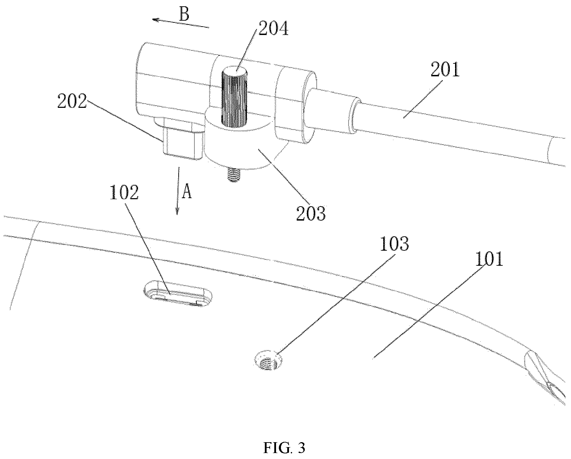

In some embodiments, as illustrated in FIG. 3 to FIG. 5, the fixing structure includes a fixing base 203 and a fastener 204. The fixing base 203 is disposed on one side of the connection plug 202. The fastener 204 is movably disposed on the fixing base 203. The housing 101 has an engagement portion, and the fastener 204 is fixedly connected to the engagement portion.

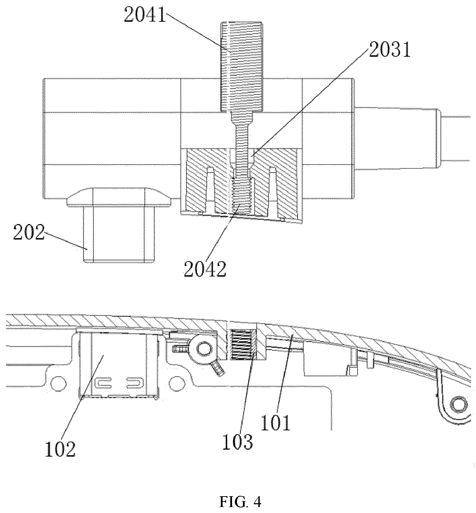

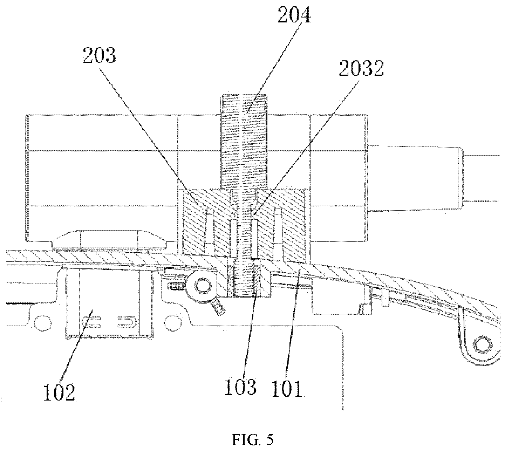

According to the invention, the fixing structure includes the fixing base 203 and the fastener 204, the fixing base 203 is disposed on one side of the connection plug 202. In an embodiment not according to the invention, the fixing base 203 may be integrally formed with the connection plug 202. According to the invention, the fixing base 203 is detachably sleeved on one side of the connection plug 202. The fixing base 203 is disposed on one side of the connection plug 202, and the fastener 204 may be movably disposed on the fixing base 203 (referring to FIG. 4 and FIG. 5). After the connection plug 202 is connected to the data interface 102, the fastener 204 may be connected to an engagement portion disposed on the housing 101 to realize the purpose of fixing the connection plug 202. The engagement portion may be set in term of its structure according to the type of the fastener 204. In an example, if the fastener 204 is a screw, the engagement portion is a nut matching the screw to realize the connection. In another example, if the fastener 204 is a clamp, the engagement portion is a holder matching the clamp to realize fixed connection. In addition, by movably disposing the fastener 204 on the fixing base 203, the connection plug 202 can be prevented from being affected by the fastener 204 when the connection plug 202 is plugged into the data interface 102.

In some embodiments, as illustrated in FIG. 3 to FIG. 9, the fixing base 203 has a through hole 2031, and a part of the fastener 204 penetrates and is disposed in the through hole 2031. The fastener 204 has a limiting end 2041 and a fastening end 2042. The limiting end 2041 is an end located outside the through hole 2031, and has a greater diameter than the through hole 2031. The fastening end 2042 is fixedly connected to the engagement portion.

For example, in this embodiment, the fixing base 203 has the through hole 2031, and a part of the fastener 204 penetrates and is disposed in the through hole 2031. An end of the fastener 204, which protrudes from an upper part of the through hole 2031 and is exposed to the outside, serves as the limiting end 2041. The other end of the fastener 204, which protrudes from a lower part of the through hole 2031 and is exposed to the outside, serves as the fastening end 2042. Since the limiting end 2041 has a greater diameter than the through hole 2031, the limiting end 2041 can be prevented from falling into the through hole 2031, and thus the fastening end 2042 can be fixedly connected to the engagement portion by means of the limiting end 2041.

In some embodiments, as illustrated in FIG. 3 to FIG. 9, the fastening end 2042 has threads, and the engagement portion has a threaded hole 103. When the connection plug 202 is plugged into the data interface 102, the threaded hole 103 is at a position corresponding to the fastening end 2042, thereby allowing the fastening end 2042 to be connected to the threaded hole 103 through the threads.

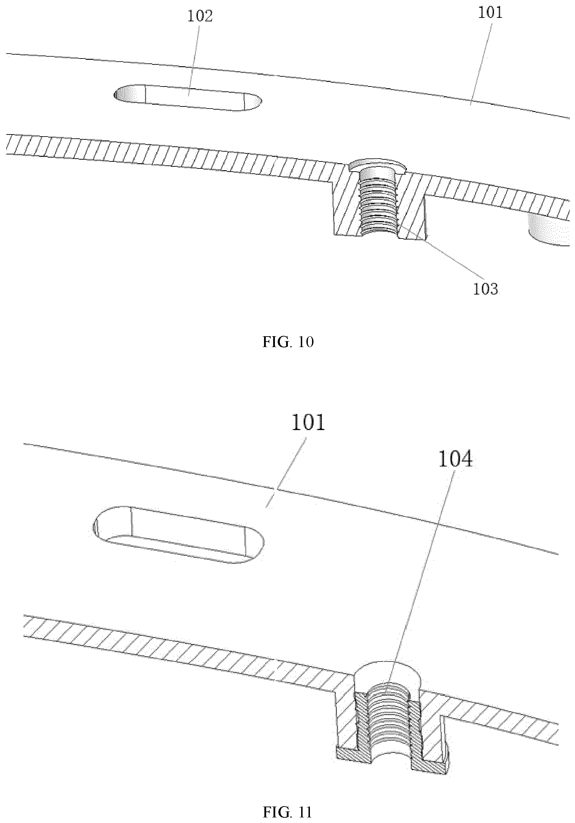

For example, threaded connection is a simple and reliable connection method. In this embodiment, the fastening end 2042 has the threads, the engagement portion has the threaded hole 103 (referring to FIG. 10), and a reliable connection between the electronic device 100 and the data cable 200 can be established through engagement of the threads and the threaded hole 103. In actual use, the connection plug 202 may be first connected to the data interface 102, the fastening end 2042 of the fastener 204 faces the threaded hole 103 of the engagement portion subsequent to a successful connection, and the threads of the fastening end 2042 are engaged with the threaded hole 103 through screwing the limiting end 2041.

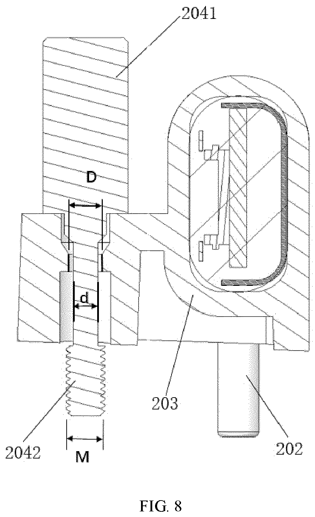

In some embodiments, referring to FIG. 8, the fastening end 2042 has a greater diameter than the through hole 2031. The diameter of the fastening end 2042 is greater than the diameter of the through hole 2031 by 0.1 to 0.5 mm.

For example, due to the fact that the diameter (M) of the fastening end 2042 is greater than the diameter (d) of the through hole 2031, the fastening end 2042 of the fastener 204 can be prevented from falling through the through hole 2031, and thus the data cable 200 is convenient to carry. In addition, in practical applications, the data cable 200 is usually wrapped with a skin made of soft material, and the fixing base 203 may also be made of the same material as the skin to reduce the production cost and simplify the production process. In production, the fastening end 2042 may be directly pushed into the through hole 2031 by external force, and then it penetrates the through hole 2031 to protrude from one end of the through hole 2031. By setting the diameter of the fastening end 2042 to be greater than that of the through hole 2031 by 0.1 to 0.5 mm, on the one hand, the fastening end 2042 can pass through the through hole 2031 conveniently, and on the other hand, the fastening end 2042 can be prevented from disengaging from the through hole 2031 after assembling is completed.

In some embodiments, as illustrated in FIG. 8 to FIG. 9, a limiting boss 2032 is disposed in a middle section of the through hole 2031, and the limiting boss 2032 can limit a detachment of the fastener 204 from the through hole 2031.

For example, the limiting boss 2032 disposed in the middle section of the through hole 2031 indicates that the through hole 2031 is narrower in the middle and wider at two ends. Accordingly, the fastener 204 is also narrower in the middle section and wider at two ends. With such a structure, the fastener 204 can be prevented from disengaging from the two ends, the integrity of the fixing structure and the whole data cable 200 can be strengthened, and portability is improved. In addition, since the fastener 204 must to be fixedly connected to the engagement portion, the movement of the fastener 204 on the fixing base 203 is limited within a certain movement range by the limiting boss 2032, which also facilitates the determination of a position of the engagement portion. The limiting end 2041 may further have antiskid texture. The limiting end 2041 is generally required when fixedly connecting the fastener 204 to the engagement portion by external force. By providing the antiskid texture on the limiting end 2041, the friction force can be increased, and the fastener 204 can be fixed to the engagement portion by screwing or in other manners, thereby further enhancing the reliability of connection between the data cable 200 and the electronic device 100.

In the invention, a plugging direction of the connection plug 202 is perpendicular to an extension direction of the cable body 201.

For example, as illustrated in FIG. 3, a plug-in direction (A) of the connection plug 202 is perpendicular to an extension direction (B) of the cable body 201. In this way, a distance between the fixing structure and the connection plug 202 can be adjusted according to a specific structure of the electronic device 100, and a plug connection between the connection plug 202 and the data interface 102 is prevented from being affected by an excessively small distance between the connection plug 202 and the fixing structure.

In some embodiments, as illustrated in FIG. 8 to FIG. 9, the fixing structure includes a knob screw, and the housing 101 has a metal nut 104 embedded therein. When the connection plug 202 is connected to the data interface 102, the metal nut 104 is opposite to the knob screw, and thus the knob screw can be engaged with the metal nut 104.

For example, the housing 101 of the electronic device 100 may be made of plastic or other deformable material, which may likely lead to the problem of connection failure in the process of connecting the fixing structure to the housing 101. In this embodiment, the fixing structure includes the knob screw, the housing 101 has the metal nut 104 with the internal threaded hole 103 embedded therein; and the metal nut 104 can engage with the knob screw (referring to FIG. 11), such that the connection between the metal nut 104 and the knob screw is more reliable and firmer.

In some embodiments, the metal nut 104 and the housing 101 are formed as one piece.

For example, in actual production, the metal nut 104 may be embedded in an injection mold, and the housing 101 is formed by injection molding. In this way, the metal nut 104 and the housing 101 are directly formed by injection molding. As for such a connection manner of the metal nut 104 and the housing 101, on the one hand, the process is simple, and the production cost can be reduced; and on the other hand, the tightness of the connection can be strengthened, and the metal nut 104 can be prevented from detaching from the housing 101.

In some embodiments, as illustrated in FIG. 11, an end, facing away from a surface of the housing 101, of the metal nut 104 has a flange to block a movement of the metal nut 104 toward the surface of the housing 101.

For example, after the knob screw is connected to the metal nut 104, the flange enables the metal nut 104 to be more firmly embedded in the housing 101 under the action of various external forces, preventing the detachment of the metal nut 104.

## Claims

1. An electronic device assembly, comprising:
an electronic device (100) comprising a housing (101), the housing (101) having a data interface (102); and
a data cable (200) comprising a cable body (201), a connection plug (202) disposed at one end of the cable body (201), and a fixing structure disposed on a side of the connection plug (202), wherein:
when the connection plug (202) is plugged in the data interface (102), the fixing structure is capable of fixing the connection plug (202) to the housing (101),
the fixing structure comprises a fixing base (203) disposed on the side of the connection plug (202), and a fastener (204) movably disposed on the fixing base (203); the housing (101) has an engagement portion; and the fastener (204) is fixedly connected to the engagement portion,
wherein the fixing base (203) has a first through hole and a second through hole (2031) perpendicular to each other, a direction of the first through hole being parallel to an extending direction of the cable body (201), a direction of the second through hole (2031) being perpendicular to the extending direction of the cable body (201), the fixing base (203) being detachably sleeved on the side of the connection plug (202) via the first through hole, and a part of the fastener (204) penetrating and disposed in the second through hole (2031); and
the fastener (204) comprises a limiting end (2041) and a fastening end (2042), the limiting end (2041) being located at outside of the second through hole (2031) and having a greater diameter than the second through hole (2031), and the fastening end (2042) being configured to be fixedly connected to the engagement portion,
**characterized in that** a plug-in direction of the connection plug (202) is perpendicular to an extension direction of the cable body (201).

2. The electronic device assembly according to claim 1, wherein:
the fastening end (2042) has threads;
the engagement portion has a threaded hole (103); and
when the connection plug (202) is plugged in the data interface (102), the threaded hole (103) is located at a position corresponding to the fastening end (2042), enabling the fastening end (2042) to be connected to the threaded hole (103) through the threads.

3. The electronic device assembly according to claim 1, wherein a diameter of the fastening end (2042) is greater than the diameter of the second through hole (2031) by 0.1 mm to 0.5 mm.

4. The electronic device assembly according to claim 1, wherein the second through hole (2031) has a limiting boss (2032) disposed in a middle section of the second through hole (2031), the limiting boss (2032) being configured to limit a detachment of the fastener (204) from the second through hole (2031).

5. The electronic device assembly according to claim 1, wherein:
the fixing structure comprises a knob screw;
the housing (101) has a metal nut (104) embedded therein; and
when the connection plug (202) is connected to the data interface (102), the metal nut (104) is opposite to the knob screw, enabling the knob screw to be engaged with the metal nut (104).

6. The electronic device assembly according to claim 5, wherein the metal nut (104) and the housing (101) are formed into one piece.

7. The electronic device assembly according to claim 5, wherein the metal nut (104) has a flange disposed at an end of the metal nut (104) facing away from a surface of the housing (101), the flange being configured to block a movement of the metal nut (104) toward the surface of the housing (101).

## Patentansprüche

1. Elektronische Vorrichtungsanordnung, umfassend:
eine elektronische Vorrichtung (100), die ein Gehäuse (101) umfasst, wobei das Gehäuse (101) eine Datenschnittstelle (102) aufweist; und
ein Datenkabel (200), das einen Kabelkörper (201), einen an einem Ende des Kabelkörpers (201) angeordneten Verbindungsstecker (202) und eine an einer Seite des Verbindungssteckers (202) angeordnete Befestigungsstruktur umfasst, wobei:
wenn der Verbindungsstecker (202) in die Datenschnittstelle (102) eingesteckt wird, die Befestigungsstruktur in der Lage ist, den Verbindungsstecker (202) am Gehäuse (101) zu befestigen,
die Befestigungsvorrichtung eine Befestigungsbasis (203) umfasst, die auf der Seite des Verbindungssteckers (202) angeordnet ist, und ein Befestigungselement (204), das beweglich auf der Befestigungsbasis (203) angeordnet ist; das Gehäuse (101) einen Eingriffsabschnitt aufweist; und das Befestigungselement (204) fest mit dem Eingriffsabschnitt verbunden ist,
wobei die Befestigungsbasis (203) ein erstes Durchgangsloch und ein zweites Durchgangsloch (2031) senkrecht zueinander aufweist, wobei eine Richtung des ersten Durchgangsloches parallel zur Erstreckungsrichtung des Kabelkörpers (201) verläuft, eine Richtung des zweiten Durchgangsloches (2031) senkrecht zur Erstreckungsrichtung des Kabelkörpers (201) verläuft, die Befestigungsbasis (203) über das erste Durchgangsloch lösbar an der Seite des Verbindungssteckers (202) angemufft ist und ein Teil des Befestigungselements (204) in das zweite Durchgangsloch (2031) eindringt und darin angeordnet ist; und
das Befestigungselement (204) ein Begrenzungsende (2041) und ein Befestigungsende (2042) umfasst, wobei sich das Begrenzungsende (2041) außerhalb des zweiten Durchgangslochs (2031) befindet und einen größeren Durchmesser als das zweite Durchgangsloch (2031) aufweist, und das Befestigungsende (2042) konfiguriert ist, um fest mit dem Eingriffsabschnitt verbunden ist,
**dadurch gekennzeichnet, dass** die Einsteckrichtung des Verbindungssteckers (202) senkrecht zu einer Erstreckungsrichtung des Kabelkörpers (201) verläuft.

2. Elektronische Vorrichtungsanordnung nach Anspruch 1, wobei:
das Befestigungsende (2042) Gewinde aufweist;
der Eingriffsabschnitt ein Gewindeloch (103) aufweist; und
wenn der Verbindungsstecker (202) in die Datenschnittstelle (102) eingesteckt wird, sich das Gewindeloch (103) an einer Position befindet, die dem Befestigungsende (2042) entspricht, wodurch es dem Befestigungsende (2042) ermöglicht wird, durch die Gewinde mit dem Gewindeloch (103) verbunden zu werden.

3. Elektronische Vorrichtungsanordnung nach Anspruch 1, wobei ein Durchmesser des Befestigungsendes (2042) um 0,1 mm bis 0,5 mm größer ist als der Durchmesser des zweiten Durchgangsloches (2031).

4. Elektronische Vorrichtungsanordnung nach Anspruch 1, wobei das zweite Durchgangsloch (2031) einen Begrenzungsvorsprung (2032) aufweist, der in einem mittleren Abschnitt des zweiten Durchgangsloches (2031) angeordnet ist, wobei der Begrenzungsvorsprung (2032) konfiguriert ist, um ein Ablösen des Befestigungselements (204) vom zweiten Durchgangsloch (2031) zu begrenzen.

5. Elektronische Vorrichtungsanordnung nach Anspruch 1, wobei:
die Befestigungsstruktur eine Rändelschraube umfasst;
das Gehäuse (101) eine darin eingebettete Metallmutter (104) aufweist; und
wenn der Verbindungsstecker (202) mit der Datenschnittstelle (102) verbunden ist, die Metallmutter (104) gegenüber der Rändelschraube liegt, wodurch es der Rändelschraube ermöglicht wird, in die Metallmutter (104) einzugreifen.

6. Elektronische Vorrichtungsanordnung nach Anspruch 5, wobei die Metallmutter (104) und das Gehäuse (101) in einem Stück gebildet sind.

7. Elektronische Vorrichtungsanordnung nach Anspruch 5, wobei die Metallmutter (104) an einem Ende der Metallmutter (104), das von einer Oberfläche des Gehäuses (101) abgewandt ist, einen Flansch aufweist, der konfiguriert ist, um eine Bewegung der Metallmutter (104) in Richtung der Oberfläche des Gehäuses (101) zu blockieren.

## Revendications

1. Ensemble de dispositif électronique comprenant :
un dispositif électronique (100) comprenant un boîtier (101), ce boîtier (101) comportant une interface de données (102) ; et
un câble de données (200) comprenant un corps de câble (201), une fiche de connexion (202) disposée à une extrémité du corps de câble (201) et une structure de fixation disposée sur un côté de la fiche de connexion (202), dans lequel :
lorsque la fiche de connexion (202) est branchée dans l'interface de données (102), la structure de fixation est capable de fixer la fiche de connexion (202) au boîtier (101),
la structure de fixation comprend une base de fixation (203) disposée sur le côté de la fiche de connexion (202), et une fixation (204) disposée de manière mobile sur la base de fixation (203) ; le boîtier (101) comporte une partie de mise en prise ; et la fixation (204) est fixée de manière fixe à la partie de mise en prise,
dans lequel la base de fixation (203) comporte un premier trou traversant et un second trou traversant (2031) perpendiculaires l'un à l'autre, la direction du premier trou traversant étant parallèle à la direction d'extension du corps du câble (201), la direction du second trou traversant (2031) étant perpendiculaire à la direction d'extension du corps du câble (201), la base de fixation (203) étant amovible par manchon sur le côté de la fiche de connexion (202) via le premier trou traversant, et une partie de la fixation (204) pénétrant et étant disposée dans le second trou traversant (2031) ; et
la fixation (204) comprend une extrémité de limitation (2041) et une extrémité de fixation (2042), l'extrémité de limitation (2041) étant située à l'extérieur du second trou traversant (2031) et présentant un diamètre supérieur à celui du second trou traversant (2031), et l'extrémité de fixation (2042) étant configurée pour être reliée de manière fixe à la partie de mise en prise,
**caractérisé en ce que** la direction d'insertion de la fiche de connexion (202) est perpendiculaire à la direction d'extension du corps du câble (201).

2. Ensemble de dispositif électronique selon la revendication 1, dans lequel l'extrémité de fixation (2042) présente des filets ;
la partie de mise en prise comporte un trou fileté (103) ; et
lorsque la fiche de connexion (202) est branchée dans l'interface de données (102), le trou fileté (103) est situé dans une position correspondant à l'extrémité de fixation (2042), permettant à l'extrémité de fixation (2042) d'être connectée au trou fileté (103) par le biais des filetages.

3. Ensemble de dispositif électronique selon la revendication 1, dans lequel le diamètre de l'extrémité de fixation (2042) est supérieur au diamètre du second trou traversant (2031) de 0,1 mm à 0,5 mm.

4. Ensemble de dispositif électronique selon la revendication 1, dans lequel le second trou traversant (2031) comporte un bossage de limitation (2032) disposé dans une section médiane du second trou traversant (2031), le bossage de limitation (2032) étant configuré pour limiter le détachement de la fixation (204) du second trou traversant (2031).

5. Ensemble de dispositif électronique selon la revendication 1, dans lequel
la structure de fixation comprend une vis à bouton ;
le boîtier (101) comporte un écrou métallique (104) encastré à l'intérieur ; et
lorsque la fiche de connexion (202) est connectée à l'interface de données (102), l'écrou métallique (104) est opposé à la vis à bouton, permettant à la vis à bouton de se mettre en prise avec l'écrou métallique (104).

6. Ensemble de dispositif électronique selon la revendication 5, dans lequel l'écrou métallique (104) et le boîtier (101) sont formés d'une seule pièce.

7. Ensemble de dispositif électronique selon la revendication 5, dans lequel l'écrou métallique (104) comporte une bride disposée à une extrémité de l'écrou métallique (104) faisant face à une surface du boîtier (101), la bride étant configurée pour bloquer un mouvement de l'écrou métallique (104) vers la surface du boîtier (101).
